# EUROPÄISCHE PATENTSCHRIFT

(11) **EP 3 250 958 B1**
(45) Veröffentlichungstag und Bekanntmachung des Hinweises auf die Patenterteilung: **05.12.2018**
(21) Anmeldenummer: 16702682.2
(22) Anmeldetag: 27.01.2016
(51) Int. Cl.: F21V 5/02, F21V 7/05, F21V 13/04, H01L 33/58, G02B 27/09, B23K 26/067, G02B 27/42, B29C 65/16, B23K 26/38

(54) **VORRICHTUNG ZUR MATERIALBEARBEITUNG MITTELS LASERSTRAHLUNG**
DEVICE FOR MACHINING MATERIAL BY MEANS OF LASER RADIATION
DISPOSITIF D'USINAGE DE MATÉRIAU PAR RAYONNEMENT LASER

(30) Priorität: 28.01.2015 DE 102015101263
(43) Veröffentlichungstag der Anmeldung: 06.12.2017
(73) Patentinhaber: Precitec GmbH & CO. KG, 76571 Gaggenau-Bad Rotenfels (DE)
(72) Erfinder: RUDOLF, Andreas, 76456 Kuppenheim (DE); SCHÖNLEBER, Martin, 63743 Aschaffenburg (DE)
(74) Vertreter: Ter Meer Steinmeister & Partner
(86) Internationale Anmeldenummer: PCT/EP2016/051702
(87) Internationale Veröffentlichungsnummer: WO 2016/120327

(56) Entgegenhaltungen:
- EP-A2- 2 760 622
- WO-A1-95/18984
- US-A- 3 726 595
- US-A- 5 548 444
- US-A1- 2005 098 260

## Beschreibung

Die Erfindung betrifft eine Vorrichtung zur Materialbearbeitung mittels Laserstrahlung.

Bei der Laserbearbeitung, also bei Materialbearbeitung mittels Laserstrahlung, wie beispielsweise Laserschweißen oder Laserschneiden wird der von einer Laserlichtquelle, beispielsweise dem Ende einer Laserleitfaser austretende Laserstrahl mit Hilfe einer Strahlführungs- und Fokussieroptik auf das zu bearbeitende Werkstück fokussiert. Der Durchmesser des Fokus, also der Durchmesser des Bildes der Laserlichtquelle auf dem Werkstück ergibt sich dann aus den optischen Daten der einzelnen optischen Elemente der Führungs- und Fokussieroptik. Wird standardmäßig eine Strahlführungs- und Fokussieroptik mit einer Kollimatoroptik und einer Fokussieroptik verwendet, der das Laserlicht über eine Lichtleitfaser zugeführt wird, so ergibt sich der Fokusdurchmesser aus dem Produkt von Faserkerndurchmesser und Fokussierbrennweite geteilt durch die Kollimationsbrennweite.

Zum Laserschneiden werden - je nach Blechdicke - unterschiedliche Laserstrahldurchmesser im Fokus benötigt. Dabei sollte der Laserstrahldurchmesser umso größer sein, je größer die Dicke des zu schneidenden Materials ist. Beispielsweise wird bis zu einer Blechdicke von 5 mm ein Fokusdurchmesser von ca. 125 µm verwendet, während beim Schneiden von 5 mm bis 10 mm dicken Blechen ein doppelt so großer Fokusdurchmesser, also ein Fokusdurchmesser von ca. 250 µm gewünscht wird. Ab Blechdicken von 10 mm werden Führungs- und Fokussieroptiken eingesetzt, die einen Fokusdurchmesser von ca. 600 µm oder mehr liefern. Eine hohe Schnittkantenqualität ist aber nur durch eine maßgeschneiderte Strahlkaustik zu erreichen. Andernfalls bilden sich Riefen, Grate und Bärte an der Schnittkante.

Bei großen Fokusdurchmessern ist es vorteilhaft, ein Ringprofil der Intensitätsverteilung im Fokus auszubilden, da sich hierdurch eine homogenere Temperaturverteilung in der Schnittfuge ergibt. In der Folge kann die Schmelze durch das Schneidgas wirksamer ausgetrieben werden.

Aus der DE 28 21 883 C2 ist bereits eine Vorrichtung zur Materialbearbeitung wie Bohren, Stanzen und Schweißen mit Hilfe von Laserstrahlen bekannt, bei der zwischen einer Kollimatoroptik zum Aufweiten des Laserstrahls und einer Fokussieroptik zum Fokussieren des Laserstrahls auf ein Werkstück ein aus durchsichtigem brechendem Material bestehender Konus (Axicon) zur achsensymmetrischen Inversion der achsennahen und achsenfernen Querschnittsbereiche des Laserbearbeitungsstrahls erreicht wird. Die Fokussieroptik fokussiert dann den Laserbearbeitungsstrahl entsprechend seiner geänderten Strahlcharakteristik in einen ringförmigen Bereich auf dem Werkstück. Durch den Einsatz des Axicon ist also die Intensitätsverteilung im Laserbearbeitungsstrahl so geändert, dass sich im Fokusbereich ein Ringprofil ergibt.

Bei der aus der DE 10 2013 102 442 A1 bekannten optischen Vorrichtung zur Verwendung bei der Lasermaterialbearbeitung sind zwischen einer Fokussieroptik und Kollimatoroptik zwei refraktive Optiken vorgesehen, die sich quer zum Laserstrahl verschieben lassen. Die refraktiven Optiken sind dabei als plattenförmige Elemente ausgebildet, deren einander zugewandte Flächen so geformt sind, dass durch die Verschiebung ein Axicon mit variablem Kegelwinkel nachgebildet werden kann. Dadurch ist sowohl ein Tophatprofil als auch ein Ringprofil erzeugbar. Der Ringdurchmesser kann dabei stufenlos eingestellt werden.

Aus der WO 2013/086227 A1 ist eine Vorrichtung bekannt, bei der die Strahlcharakteristik im Fokus auf dem Werkstück nicht durch einen Eingriff in Strahlführungs- und Fokussieroptik erfolgt, sondern dadurch, dass die Strahlcharakteristik am Laserlichtaustrittsende einer die Laserstrahlung zur Strahlführungs- und Fokussieroptik liefernden Glasfaser erfolgt. Hierzu wird der Laserstrahl mit Hilfe einer verschiebbaren Einkoppelungsvorrichtung unter verschiedenen Winkeln in die Prozessfaser eingekoppelt, um nur wenige der Faser-Moden anzuregen. Dadurch ist sowohl ein Gauß/TophatProfil als auch ein Ringprofil erzeugbar. Auch kann der Ringdurchmesser stufenlos eingestellt werden. Hier wird also die physikalische Eigenschaft einer Glasfaser ausgenutzt, dass die numerische Apertur auf der Einkoppelungsseite gleich der numerischen Apertur auf der Austrittsseite der Faser ist.

Ferner wurden bereits reflektive Glasplatten mit umfangsmäßigen oder azimutalen Phasenrampen vorgeschlagen, die in Umfangsrichtung ein Sägezahn-Profil bilden. Dabei ist das Sägezahn-Profil innen stärker geneigt als außen. Mit derartigen Elementen lässt sich ein Ring mit festem Durchmesser erzeugen.

Aus der DE 10 2011 113 980 A1 ist ein Linsensystem mit veränderbarer Refraktionsstärke bekannt, bei dem zwei plankonvexe Linsen mit ihren ebenen Flächen um die optische Achse verdrehbar aufeinander angeordnet sind. Die konvexen Linsenflächen sind dabei jeweils mit einem wendelähnlichen Krümmungsprofil mit einer um die Drehachse winkelabhängig stetig ansteigenden oder abfallenden Refraktionsstärke und mit jeweils mindestens einer azimutalen Refraktionsstärkenstufe an einem jeweiligen Nullwinkel versehen. Bei der Rotation der Linsen gegeneinander verändert sich die Refraktionsstärke und damit die Brennweite des Linsenpaars. Die azimutalen Stufen müssen dabei abgedeckt werden.

Die US 2007/0139798 A1 betrifft einen LED Strahler mit einem radialprismatischen Lichtverteiler. Der radialprismatische Lichtverteiler, der in Hauptabstrahlrichtung vor der LED angeordnet ist, weist dabei auf der von der LED abgewandten Seite eine Fläche mit einem kreisförmigen Muster aus sektorförmigen Facetten auf, die in Umfangsrichtung abwechselnd gegen die jeweilige Plattenebene geneigt sind.

Ferner ist es bekannt, dass Probleme beim Laserschweißen, wie die Bildung von Spritzern und Poren durch schnelle, periodische Auslenkung des Arbeitslaserstrahls verringert werden können.

Beispielsweise ist aus der WO 2014/038395 A1 ein Laserbearbeitungskopf bekannt, bei dem eine motorisch rotierende Keilplatte im Strahlgang angeordnet ist, um den Arbeitslaserstrahls auf eine Kreisbahn zu lenken

Aus der DE 10 2012 008 940 A1 ist ein weiterer Laserbearbeitungskopf bekannt, bei dem der Vorschubgeschwindigkeit des Laserstrahls in y-Richtung eine zweite Bewegung mit einer oszillierenden Bewegungskomponente in x- Richtung überlagert wird, so dass der Laserstrahl zur Bearbeitung des Werkstücks dieses auf kreisähnlicher Bahn überquert.

Bei einem aus der US 8237085 B2 bekannten Laserbearbeitungskopf wird die Intensitätsverteilung des Laserstrahls durch Oszillation von Spiegeln senkrecht zur Strahlachse zeitlich gemittelt.

Aus der DE 44 30 220 A1 ist ein Schwingspiegelbearbeitungskopf bekannt, in den Fokussierspiegel, Planspiegel und Galvanoscanner integriert sind. Ein Laserstrahl wird durch den Fokussierspiegel fokussiert und über den Planspiegel, der von dem Galvanoscanner angesteuert wird, auf ein Werkstück gelenkt. Die Laserstrahlformung erfolgt auf der Basis einer sinusförmigen, harmonischen Strahloszillation als Ansteuerfunktion durch den Galvanoscanner, um die Intensitätsverteilung auf dem Werkstück zu steuern.

Die DE 10 2014 105 941 A1 beschreibt ein Verfahren zum Laserstrahlschweißen bei dem der Laserstrahl während des Schweißens eine räumlich oszillierende Bewegung parallel und/oder senkrecht zur Schweißnaht ausführt, und bei dem die Erstarrung des Schmelzbades durch eine zusätzliche und synchron zur räumlichen Oszillation durchgeführte zeitliche Oszillation der Laserstrahl-Intensität und/oder der Laserstrahl-Kollimation gesteuert wird. Die zeitlichen Oszillationen der Laserstrahl-Energie werden hier durch eine Variation der Laserleistung der Strahlquelle und/oder durch eine Kollimationsverstellung in axialer Strahlrichtung, also eine Aufweitung oder Fokussierung des Lichtstrahls erreicht.

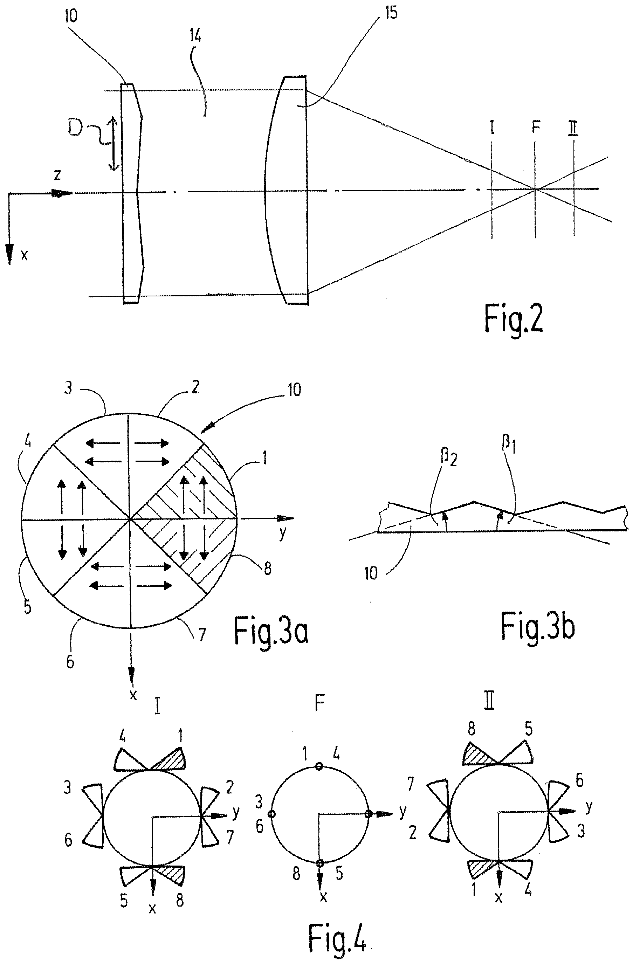

Die US 2005/0098260 betrifft ein Verfahren und eine Vorrichtung zum Erwärmen von Kunststoffen mittels Laserstrahlen und beschreibt anhand von Figur 2 einen Bearbeitungskopf 13 mit einer Glaskugel 22 als Druck- und Führungselement für den Laserstrahl (siehe Seite 1, Absatz [0013]). In dem Bearbeitungskopf ist eine Kollimatoroptik 3 und eine Fokussierlinse 8 angeordnet, die einen über eine optische Faser 1 gelieferten Laserstrahl 2 in eine Brennebene 9 durch die Glaskugel 22 hindurch fokussiert. Im parallelen Strahlengang zwischen der Kollimatoroptik 3 und der Fokussierlinse 8 ist eine doppelte Keilplatte 4 angeordnet, die den Laserstrahl 2' in zwei Teilstrahlen 2" aufteilt, so dass in der Fokusebene 9 zwei Laserpunkte 10, 11 vorhanden sind. Wie auf Seite 2 im Absatz [0022] beschrieben ist, kann mit zwei Laserpunkten durch Rotieren der Doppelkeilplatte ein Ring gebildet werden. Die Anzahl der Strahlen und damit der Laserpunkte kann durch Vergrößern der Anzahl der Keile erhöht werden. In der Figur 3A wird eine Keilplatte mit drei Keilen, in der Figur 4B eine Keilplatte mit 4 Keilen und in Figur 3C eine Keilplatte mit fünf Keilen gezeigt.

Der Erfindung liegt die Aufgabe zugrunde, eine Vorrichtung und ein Verfahren zur Materialbearbeitung mittels Laserstrahlung bereit zu stellen, mit deren Hilfe sowohl der Fokusdurchmesser als auch die Strahlcharakteristik insbesondere im Fokusbereich also die Energieverteilung im Fokusbereich ohne Austausch von Komponenten der Führungs- und Fokussieroptik auch im laufenden Betrieb geändert werden kann. Diese Aufgabe wird erfindungsgemäß durch die Vorrichtung zur Materialbearbeitung mittels Laserstrahlung gemäß Anspruch 1 und das Verfahren nach Anspruch 20 gelöst. Vorteilhafte Ausgestaltungen und Weiterbildungen der Erfindung sind in den jeweiligen Unteransprüchen beschrieben.

Erfindungsgemäß weist also die Vorrichtung zur Materialbearbeitung mittels Laserstrahlung zumindest einem plattenförmigen optischen Element im Strahlengang des Laserstrahls auf, dessen eine Fläche mit einem kreisförmigen Muster aus sektorförmigen Facetten versehen ist, die in Umfangsrichtung abwechselnd gegen die jeweilige Plattenebene geneigt sind. Mit einem derartigen optischen Element wird der Laserfokus in der Brennebene in eine Vielzahl von Punkten zerlegt, die ringförmig um die optische Achse des Strahlengangs angeordnet sind. Wird nun das plattenförmige optische Element in den Strahlengang des Laserstrahls hinein und heraus bewegt, so kann eine Leistungsdichteverteilung des Laserstrahls in Brennebene zwischen Punktverteilung (Spot) und Ringverteilung (Ring) umgeschaltet werden.

Gemäß einem weiteren Aspekt der Erfindung weist die Vorrichtung zur Materialbearbeitung mittels Laserstrahlung zumindest zwei plattenförmige optische Elemente auf, die hintereinander im Strahlengang in Umfangsrichtung gegeneinander verdrehbar angeordnet sind. Die plattenförmigen optischen Elemente weisen jeweils eine Fläche mit einem kreisförmigen Muster aus sektorförmigen Facetten auf, die in Umfangsrichtung abwechselnd gegen die jeweilige Plattenebene geneigt sind. Die schmalen sektorförmigen, vorzugsweise ebenen Facetten bilden also abwechselnd keilförmige Plattensektoren aus, die entsprechende sektorförmige Bereiche des Laserstrahlbündels in entgegengesetzte Richtungen auslenken.

Mit der erfindungsgemäßen Einstelloptik lässt sich je nach Winkelstellung der beiden plattenförmigen optischen Elemente gegeneinander eine punktförmige Intensitätsverteilung oder eine ringförmige Intensitätsverteilung im Brennpunkt bzw. in der Brennebene der Fokussieroptik erzeugen. Erfindungsgemäß lässt sich daher durch Verdrehen der plattenförmigen optischen Elemente gegeneinander auch während der Laserstrahlbearbeitung zwischen Ringprofil und Gauß/Tophat-Profil umschalten, so dass auch Bleche mit unterschiedlichen Materialstärken in einem Arbeitsdurchgang oder unmittelbar hintereinander ohne Umrüsten der Strahlführungs- und Fokussieroptik eines Laserbearbeitungskopfes durchgeführt werden kann.

Obwohl es grundsätzlich denkbar ist, das die sektorförmigen Facetten unterschiedlich breit sind, ist es vorteilhaft, wenn alle sektorförmigen Facetten eines plattenförmigen optischen Elements dieselbe azimutale Breite aufweisen.

Die Flächen der sektorförmigen Facetten der plattenförmigen optischen Elemente der Einstelloptik sind eben oder gekrümmt oder weisen zwei oder mehrere unterschiedlich geneigte Abschnitte auf.

Vorteilhafterweise ist vorgesehen, dass die beiden plattenförmigen optischen Elemente der Einstelloptik sich mit ihren sektorförmigen Facettenmustern gegenüber stehen, wobei die beiden plattenförmigen optischen Elemente der Einstelloptik um eine Achse verdrehbar sind, die mit einer Mittelachse eines Laserstrahlbündels koaxial ist und wobei die sektorförmigen Facettenmuster der beiden plattenförmigen optischen Elemente der Einstelloptik dieselbe Anzahl von Facetten aufweist und dass die Facettenflächen um den gleichen Winkel geneigt sind. Durch eine derartige Anordnung lässt sich erreichen, dass die Flächen der beiden optischen Elemente, die die sektorförmigen Facettenmuster tragen, sich mit sehr kleinem Abstand gegenüberstehen, so dass sich die Strahlablenkungen der beiden Flächen je nach Winkelstellung der optischen Elemente zueinander ideal ergänzen oder aufheben. Dadurch ist es möglich, sowohl ein möglichst gutes Punktprofil (Gauß/Tophat) als auch ein möglichst sauberes Ringprofil zu erhalten.

Bei einer vorteilhaften Weiterbildung der Erfindung ist vorgesehen, dass die Einstelloptik ein weiteres plattenförmiges optisches Element mit einem sektorförmigen Facettenmuster aufweist. Das weitere plattenförmige Element kann die gleichen Eigenschaften aufweisen wie die beiden ersten. Um die Energieverteilung in der Brennebene auf möglichst vielfältige Weise variieren zu können, ist insbesondere vorgesehen, dass das weitere plattenförmige optische Element ein sektorförmiges Facettenmuster aufweist, das von dem sektorförmigen Facettenmustern der beiden ersten plattenförmigen optischen Elemente verschieden ist.

Dabei können die Facettenflächen des weiteren plattenförmigen optischen Elements um einen Winkel gegen die Plattenebene geneigt sind, der vom Neigungswinkel der beiden ersten plattenförmigen optischen Elemente verschieden, insbesondere so groß ist wie die Summe der Neigungswinkel der beiden ersten plattenförmigen optischen Elemente. Durch die Kombination von drei plattenförmigen optischen Elementen mit sektorförmigen Facettenmustern im Strahlenbündel eines Laserbearbeitungsstrahls lassen sich zwei verschiedene Ringprofile miteinander kombinieren, so dass sich die Strahlcharakteristik, also die Intensitätsverteilung im Laserstrahlbündel über einen weiten Bereich variieren lässt, je nachdem welche Intensitätsverteilung für eine aktuelle Materialbearbeitung gewünscht ist.

Ferner ist es möglich, dass die Facetten des weiteren plattenförmigen optischen Elements eine azimutale Breite aufweisen, die von der azimutale Breite der Facetten der beiden ersten plattenförmigen optischen Elemente verschieden ist.

Vorteilhafterweise ist vorgesehen, dass der Neigungswinkel der Facettenflächen gegen die Plattenebene zwischen +/- 0,1° und +/-0,6° beträgt.

Eine besonders gleichmäßige Verteilung der Laserenergie in einem Ringprofil lässt sich erreichen, wenn vorgesehen ist, dass die gerade Anzahl der Facetten 18 bis 72, vorzugweise 24 bis 40, insbesondere 36 beträgt.

Obwohl es grundsätzlich möglich ist, die erfindungsgemäße Einstelloptik auch im divergenten oder konvergenten Bereich eines Laserstrahlbündels anzuordnen, ist erfindungsgemäß vorgesehen, dass eine Kollimatoroptik zur Aufweitung des Laserstrahls vorgesehen ist, und dass die Siemensstern-Optik zwischen der Kollimatoroptik und der Fokussieroptik angeordnet ist.

Bei einer vorteilhaften Ausgestaltung der Erfindung ist vorgesehen, dass zumindest einem der plattenförmigen optischen Elemente ein Drehantrieb zugeordnet ist, so dass das plattenförmige optische Elemente während eines Laserbearbeitungsprozesses antreibbar ist, um mit konstanter oder veränderlicher Geschwindigkeit zu rotieren.

Weist die Einstelloptik zwei oder mehr plattenförmige optische Elemente auf, lässt sich dadurch die Leistungsdichteverteilung des Laserstrahls periodisch variieren, wodurch bei Verwendung entsprechend hoher Modulationfrequenzen eine quasi kontinuierliche Strahlaufweitung im Fokus erreicht wird.

Ist nur ein plattenförmiges optisches Element vorhanden, so kann zwar durch die Rotation des plattenförmigen optischen Elements die Leistungsdichteverteilung des Laserstrahls nicht moduliert werden, jedoch ist es in vorteilhafter Weise möglich, die Leistungsdichteverteilung im Ringprofil in Umfangsrichtung zeitlich zu homogenisieren, da das Ringprofil selbst in einer Ebene parallel zur Ebene des plattenförmigen optischen Elements rotiert, da also die einzelnen Lichtflecken des Ringprofils quasi die optische Achse umlaufen. Die zeitliche Verteilung der Leistungsdichte in einem Punkt des Ringprofils entspricht dabei der räumlichen Verteilung in Umfangsrichtung. Damit lassen sich nicht nur durch die Punktstruktur bedingte Leistungsdichteunterschiede ausgleichen, sondern auch solche die auf Fertigungstoleranzen basieren.

Zweckmäßiger Weise ist jedem der plattenförmigen optischen Elemente ein eigener Drehantrieb zugeordnet, wobei die Drehantriebe unabhängig voneinander ansteuerbar sind, so dass die Drehgeschwindigkeit und Drehrichtung jedes der plattenförmigen optischen Elemente frei gewählt werden kann. Mir einer derartigen Vorrichtung lässt sich die Leistungsdichteverteilung des Laserstrahls sowohl zeitlich über die Drehgeschwindigkeiten als auch räumlich über die gewählte geometrische Struktur der sektorförmigen Facetten und die Aktivierung oder Deaktivierung der einzelnen Drehantriebe variieren.

Bei der Materialbearbeitung mittels Laserstrahlung unter Verwendung einer erfindungsgemäßen Vorrichtung wird vorteilhafter Weise während der Laserbearbeitung zumindest eines der plattenförmigen optischen Elemente mit konstanter oder variabler Geschwindigkeit gedreht wird, um eine Leistungsdichteverteilung mit einer gewünschten Modulationsfrequenz zu variieren.

Zweckmäßiger Weise kann dabei vorgesehen sein, dass beide der zumindest zwei plattenförmigen optischen Elemente in entgegengesetzte Richtungen mit gleicher oder unterschiedlicher Geschwindigkeit gedreht werden, so dass sich die Modulation der Leistungsdichteverteilung an die jeweiligen Erfordernisse der Bearbeitungsaufgabe anpassen lassen.

Um nicht nur die Leistungsdichteverteilung, sondern auch Leistung selbst bei der Laserbearbeitung variieren zu können, wird die Ausgangsleistung des Lasers moduliert, während eines oder mehrere der plattenförmigen optischen Elemente gedreht werden, wobei eine Modulationsfrequenz des Lasers an die Modulationsfrequenz der Leistungsdichteverteilung gekoppelt ist.

Die Erfindung wird im Folgenden beispielsweise anhand der Zeichnung näher erläutert. Es zeigen:
Figur 1 eine perspektivische Ansicht eines plattenförmigen optischen Elements mit Siemenssterngeometrie, bei der der Neigungswinkel der Facettenflächen übertrieben groß dargestellt ist,
Figur 2 eine schematische Darstellung einer Fokussieroptik zur Fokussierung eines parallelen Strahlenbündels, wobei im Strahlenbündel ein einzelnes plattenförmiges optisches Element einer Einstelloptik angeordnet ist,
Figur 3a eine schematische Draufsicht auf ein vereinfachtes plattenförmiges optisches Element einer Einstelloptik mit acht Facetten,
Figur 3b eine Seitenansicht (Abwicklung) eines plattenförmigen optischen Elements für eine erfindungsgemäße Einstelloptik,
Figur 4 schematische Darstellungen der Strahlcharakteristik vor der Brennebene, in der Brennebene und dahinter,
Figur 5 eine erfindungsgemäße Anordnung von zwei plattenförmigen optischen Elementen zur Bildung einer Einstelloptik,
Figur 6 eine Strahlführungs- und Fokussieroptik wie sie zur Laserbearbeitung in einem Laserbearbeitungskopf eingesetzt wird, in deren Laserstrahlengang eine Einstelloptik mit zwei plattenförmigen optischen Elementen angeordnet ist, und
Figur 7 eine erfindungsgemäße Anordnung von drei plattenförmigen optischen Elementen zur Bildung einer Einstelloptik, wobei das mittlere beidseitig strukturiert ist.

In den Figuren werden einander entsprechende Bauteile mit gleichen Bezugszeichen versehen.

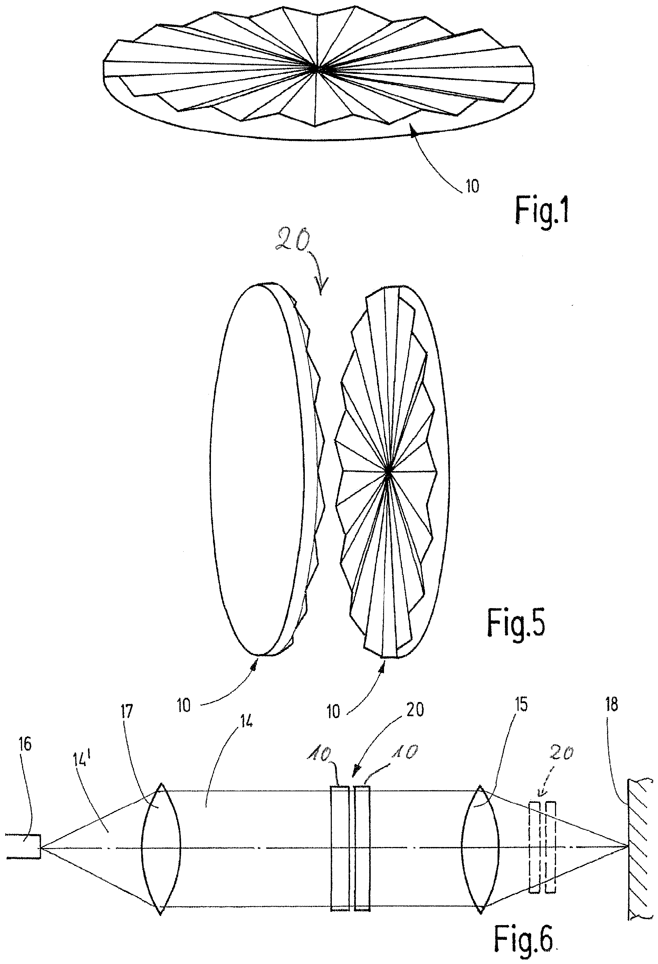

Figur 1 zeigt ein plattenförmiges optisches Element 10, das aus einer transparenten Scheibe, insbesondere aus einem Planglas aus Quarzglas oder Zinksulfid besteht, die auf einer Seite siemenssternartige Facetten aufweist, die in azimutaler oder Umfangsrichtung geneigt sind. Die Facetten sind also schmale Sektoren oder Kreisausschnitte, die ähnlich wie das als Siemensstern bekannte kreisförmige Testmuster, das abwechselnd weiße und schwarze Sektoren besitzt, ebenfalls eine in Umfangsrichtung abwechselnde Neigung besitzen. Zwei benachbarte Facetten bilden somit eine Dachform oder eine V-förmige Talform, wobei zwei Facetten, die gemeinsam eine Dachform bilden, jeweils mit ihren anderen benachbarten Facetten jeweils eine V-Form ausbilden. Das plattenförmige optische Element mit den siemenssternförmig angeordneten Facetten wird in Anlehnung an den bekannten Siemensstern zum Testen der Abbildungsqualitäten im Folgenden als Siemenssternoptik bezeichnet wird.

Die Facettenfläche jedes Sektors bildet mit der ebenen Gegenfläche eine Keilplatte mit einheitlicher Strahlablenkung des zugeordneten Kreissektors des kollimierten Strahls. In der Zeichnung sind die Neigungswinkel der Facetten hier zur Veranschaulichung mit +/- 15° übertrieben groß dargestellt. Die Facetten, also die Sektoren decken jeweils einen Winkelbereich von 10° in azimutaler oder Umfangsrichtung ab. Das ergibt insgesamt 36 Facetten, also 18 Facetten je Neigungswinkel im Vollkreis.

Wird eine Siemenssternoptik 10 - wie in Figur 2 gezeigt - im aufgeweiteten parallelen Strahlengang 14 einer nicht näher dargestellten Laserstrahlquelle vor einer Fokussieroptik 15 angeordnet, so ergibt sich in der Brennebene F der Fokussieroptik 15 ein aus einzelnen Lichtpunkten (sogenannten Spots) zusammengesetztes ringförmiges Fokusbild. In den Ebenen I vor der Brennebene und II hinter der Brennebene werden die einzelnen Spots, die auf die einzelnen Facetten zurückgehen, mehr oder weniger verschmiert dargestellt.

Im Folgenden wird eine stark vereinfachte Siemenssterngeometrie mit acht kreissektorfömigen Facetten beschrieben. Gemäß Figur 3a weist die Siemenssternoptik 10 acht Facetten 1 bis 8 auf, die so geneigt sind, dass jeweils zwischen den Facetten 1 und 2, 3 und 4, 5 und 6, 7 und 8 eine Dachlinie liegt, während zwischen den Facetten 2 und 3, 4 und 5, 6 und 7, 1 und 8 jeweils eine Tallinie liegt. Die jeweiligen Neigungswinkel β1, β2 sind dabei also abwechselnd positiv und negativ, wie in Figur 3 dargestellt ist. Die Neigung wird dabei gegenüber der Plattenebene bestimmt, also in Bezug auf die Ebene der planen Seite der plattenförmigen Siemenssternoptik 10.

Der kollimierte Laserstrahl 14 fällt in Figur 2 auf die Siemenssternoptik 10 und wird anschließend durch die Fokussierlinse 15 in die Fokusebene F gebündelt. Durch die Facettierung, die in Figur 3a dargestellt ist, ergibt sich eine segmentweise Strahlablenkung in unterschiedlichen Richtungen. In Figur 4 sind die Strahlprofile vor (Ebene I), in (Fokusebene F) und hinter (Ebene II) der Fokusebene F dargestellt. In den Strahlprofilen vor und hinter der Fokusebene F zeichnet sich aufgrund der Defokussierung die Dreiecksform der Facetten ab, während sich das Strahlprofil im Fokus selber aus einzelnen Punkten oder Spots zusammensetzt.

Der Ablenkwinkel θ, der durch die Brechung des verzugsweise kollimierten Laserstrahls 14 an einer geneigten Facette hervorgerufen wird, berechnet sich aus dem Neigungswinkel β und dem Brechungsindex n des verwendeten Materials. Der Ablenkwinkel θ ist also θ = β (n - 1). Diese Formel gilt unter der Voraussetzung, dass die Kleinwinkelnäherung (sin ϕ ≈ tan ϕ ≈ ϕ) hinreichend erfüllt ist, was bis zu einem Winkel von etwa 5° gegeben ist. Aus dem Ablenkwinkel θ und der Fokussierbrennweite f errechnet sich der Ringdurchmesser im Fokus zu:
Ring-Ø = 2 · f · tan θ. Hier einige Beispiele:

| Facetten-Neigungswinkel β | 0,1° | 0,2° | 0,4° |
|---|---|---|---|
| Ring-Ø im Fokus bei f=100mm | 157 µm | 314 µm | 628 µm |

Zur Darstellung der Vorteile der erfindungsgemäßen Strahlformung mittels siemenssternförmigen Facettenstrukturen wurden Simulationen durchgeführt.

Der Grundaufbau der Strahlführungs- und Fokussieroptik ist in Figur 6 dargestellt und technische Daten sind in der folgenden Tabelle angegeben:

| | |
|---|---|
| Strahlquelle | Stufenindex-Faser, Kern-Ø = 100µm, abgestrahlte NA = 0,12 |
| Strahlquelle (alternativ) | Stufenindex-Faser mit Ringkern, Ø_{Außen} = 600 µm, Ø_{Innen} = 150 µm, NA= 0,12 |
| Kollimation | perfekte Sammellinse, f = 100 mm |
| Fokussierung | perfekte Sammellinse, f = 100 mm |

| | |
|---|---|
| Hier bedeutet Ø = Durchmesser und NA = numerische Apertur. | |

Wie in Figur 6 gezeigt, wird ein aus einer Lichtleitfaser 16 austretendes divergentes Laserlichtbündel 14' von einer Kollimatoroptik 17 in ein paralleles Laserlichtbündel 14 umgeformt, das von der Fokussierlinse 15 auf ein Werkstück 18 fokussiert wird. Gemäß Figur 6 ist eine Einstelloptik 20, also eine refraktive Optik zum Einstellen der Intensitätsverteilung in das parallele Laserlichtbündel 14 eingesetzt. Für die folgende Simulation wurde eine einzelne Siemenssternoptik mit Facettenstruktur verwendet, wie in Figur 2 dargestellt.

Mit diesem Grundaufbau wurden die folgenden vier Konfigurationen untersucht:

| # | Strahlquelle | Strahlformungsoptik |
|---|---|---|
| 1 | Kern-Ø = 100µm | keine |
| 2 | Kern-Ø = 100µm | Siemensstern-Optik zwischen den Linsen, 36 Facetten à 10° Winkelbereich mit ±0,4° Neigung |
| 3 | Kern-Ø = 100µm | Axikon zwischen den Linsen, Neigungswinkel 0,1° |
| 4 | Ringkern, Ø_{Außen} = 600 µm , Ø_{Innen} = 150 µm | keine |

Es wurde in der Simulation die Energieverteilung bzw. das Strahlprofil 3 mm vor dem Brennpunkt, im Brennpunkt und 3 mm hinter dem Brennpunkt ermittelt. Im ersten Fall wird die Strahlführungs- und Fokussieroptik gemäß Figur 6 ohne Einstelloptik verwendet. Im zweiten Beispiel wurde eine erfindungsgemäße Siemenssternoptik zwischen die beiden Linsen gesetzt. Bei einer dritten Simulation wurde ein Axikon, also ein Kegel mit einem Neigungswinkel von 0,1° im Strahlengang angeordnet. Als alternative Möglichkeit der Strahlformung mittels Fasern wurde eine Stufen-Index-Faser mit Ringkern eingesetzt, wobei wiederum keine weiteren Strahlformungselemente in den Strahlengang gegeben wurden. Die Simulationsergebnisse zeigen sich in der folgenden Tabelle:

| Konfiguration | Intensitätsprofil im axialen Abstand z von der Fokusebene, Bildausschnitt 1,6 mm x 1,6 mm | | | Beschreibung/ Bewertung |
|---|---|---|---|---|
| | z = -3 mm | z = 0 mm | z = 3 mm | |
| #1 ohne strahlformende Optik | 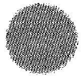 | 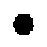 | 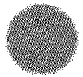 | Übliche Fokussierung mit vor- und nachgehender Strahlaufweitung |
| #2 Siemensstern-Optik | 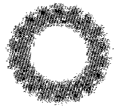 | 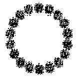 | 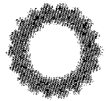 | Ringprofile mit sehr ähnlichem Ø über den gesamten z-Bereich. Aufgrund 32-fach-Facettierung sind die azimutale Intensitätsschwankungen gering, besonders außerhalb der Fokusebene. |
| #3 Axikon | 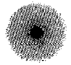 | 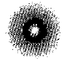 | 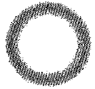 | Fokussierung des Strahls vor der eigentlichen Fokusebene. Ab der Fokusebene Ringprofil, dessen Ø mit steigendem z-Abstand stark anwächst. |
| #3 Ringkern-Faser | 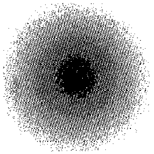 | 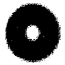 | 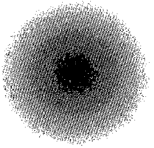 | Ringprofil wird nur in sehr kleiner z-Umgebung der Fokusebene erreicht. Davor und dahinter Gauß-ähnliches Strahlprofil. |

Die Simulationen zeigen also, dass die erfindungsgemäße siemenssternförmige Facettenstruktur eines plattenförmigen optischen Elements, also der Siemenssternoptik sich am besten eignet, um ein Ringprofil über einen möglichst weiten Bereich vor und hinter der Fokusebene zu erzeugen.

Wird nun eine einzelne Siemenssternoptik 10 in den Strahlengang des Laserstrahls 14 eingesetzt, wie in Figur 2 dargestellt, so erhält man die ringförmige Leistungsdichteverteilung entsprechend der obigen Konfiguration #2 (Ring). Um die punktförmige Leistungsdichteverteilung entsprechend der obigen Konfiguration #1 (Spot) zu erhalten, braucht nur die Siemenssternoptik 10 aus dem Strahlengang des Laserstrahls 14 herausgenommen zu werden. Um zwischen den Modi Spot und Ring und wieder zurück zum Modus Spot umzuschalten, braucht also die einzelne Siemenssternoptik 10 nur in den Strahlengang des Laserstrahls 14 eingesetzt und dann wieder herausgenommen zu werden, wie in Figur 2 durch den Doppelpfeil D angedeutet ist.

Wird die einzelne in den Strahlengang eingeschaltete Siemenssternoptik 10 durch einen geeigneten Drehantrieb, wie er unten im Zusammenhang mit einer weiteren Ausgestaltung der Erfindung näher erläutert wird, in Rotation versetzt, so ist es möglich, die Leistungsdichteverteilung im Ringprofil insbesondere in der Brennebene in Umfangsrichtung zeitlich zu homogenisieren, da das Ringprofil selbst in der Brennebene rotiert, da also die einzelnen Lichtflecken oder Spots des Ringprofils quasi um die optische Achse umlaufen. Die zeitliche Verteilung der Leistungsdichte in einem Punkt des Ringprofils entspricht dabei der räumlichen Verteilung der Leistungsdichte in Umfangsrichtung. Damit lassen sich nicht nur durch die Punktstruktur bedingte Leistungsdichteunterschiede ausgleichen, sondern auch solche die auf Fertigungstoleranzen basieren.

Um ein stufenloses Mischverhältnis zwischen punkt- und ringförmigen Profilen des Laserfokus zu erreichen, werden erfindungsgemäß zwei Siemenssternoptiken der anhand von Figur 1 bis 4 beschriebenen Art eingesetzt.

Die Hintereinanderschaltung zweier Siemenssternoptiken 10 zur Ausbildung einer erfindungsgemäßen Einstelloptik 20 zum Einstellen der Intensitätsverteilung (siehe Figur 5) führt zu einer Addition der Strahlablenkungen der einzelnen Siemenssternoptiken 10. Je nach relativer Winkelstellung der beiden Siemenssternoptiken 10 zueinander ergeben sich drei unterschiedliche Fälle. Stehen sich die Siemenssternoptiken 10 ohne Verdrehung oder um ein Vielfaches des Facettenperiodenwinkels verdreht gegenüber, stehen sich also gegensätzlich geneigte Facetten gegenüber, so addieren sich die Strahlablenkungen konstruktiv und es wird ein Ringprofil erzeugt, dessen Durchmesser doppelt so groß ist wie der bei Verwendung einer einzelnen Siemenssternoptik 10. Sind die Siemenssternoptiken um die Hälfte des Facettenperiodenwinkels gegeneinander verdreht, so dass sich gleichsinnig geneigte Facetten gegenüber stehen, wenn also den Dächern der einen Siemenssternoptik 10 die Täler der anderen Siemenssternoptik 10 und umgekehrt gegenüber stehen, werden die Strahlablenkungen der ersten Siemenssternoptik 10 von der zweiten Siemenssternoptik 10 nahezu exakt kompensiert. Die beiden Siemenssternoptiken 10 wirken in dieser Stellung wie eine planparallele Platte. Folglich wird in der Fokusebene ein punktförmiger Fokus erzeugt, so als ob keine Einstelloptik 20 vorhanden wäre. Darüber hinaus sind auch sämtliche anderen gegeneinander verdrehten Winkelstellungen möglich, so dass jeder Facette sowohl gleichsinnig als auch gegensätzlich geneigte Facetten gegenüberstehen. Es wird daher ein Mischprofil, bestehend aus einem Ring und einem Punkt erzeugt. Die Leistungsverteilung über das Strahlprofil richtet sich hier nach den jeweiligen Überlappungsgebieten.

Auch für derartige erfindungsgemäße Einstelloptiken 20 wurden entsprechende Simulationen durchgeführt. Dabei wurde die Einstelloptik 20 wie in Figur 6 dargestellt, zwischen die Kollimatorlinse 17 und die Fokussierlinse 15 eingesetzt. Wie dargestellt, wurden die Simulationen nur durchgeführt für eine Anordnung der Einstelloptik 20 im kollimierten Strahlbereich. Wie in Figur 6 gestrichelt angedeutet, dürfte jedoch auch das erfindungsgemäße Ablenkprinzip im konvergierenden Strahlbereich oder auch im divergierenden Strahlbereich (nicht dargestellt) funktionieren.

Bei der Simulation mit einer Einstelloptik 20 mit zwei Elementen, wurden plattenförmige Siemenssternoptiken 10 eingesetzt, deren siemenssternförmige Facettenstruktur Facetten mit jeweils einem Winkelbereich von 10° und einem Neigungswinkel der Facetten von +/- 0,2° aufweist. Obwohl die Elemente grundsätzlich so angeordnet werden können, dass sich beliebige Flächen gegenüberstehen, wurden hier die optischen Elemente so angeordnet, dass sie bei 1 mm Abstand sich mit ihren facettierten Flächen ähnlich wie in Figur 5 gegenüberstehen. Dies hat den Vorteil, dass sich die ablenkenden Wirkungen optimal ergänzen oder auslöschen, wie in der Tabelle unten die beiden letzten Zeilen zeigen.

Um die Eignung für den Einsatz bei der Laserbearbeitung möglichst exakt ermitteln zu können, wurden auch Fertigungstoleranzen bei der Simulation berücksichtigt. Hierzu wurden die radial verlaufenden Spitzen der Dächer und die Senken der Täler mit einer azimutalen Breite von 10 µm abgeflacht. Hierdurch ergibt sich ein Strahlanteil, der keiner Strahlformung unterliegt und somit stets in Fokuszentrum als Punkt abgebildet wird. Dieser Anteil beträgt gemäß der Simulation maximal 2%, was beim Einsatz in der Materialbearbeitung durchaus vernachlässigbar ist.

Bei der Simulation hat sich gezeigt, dass bereits in kleiner axialer Distanz von der Fokusebene (0,35 µm) die Einzelabbildung der Facetten nicht mehr erkennbar ist und dass sich somit ein nahezu homogenes Ringprofil ergibt. Zur Veranschaulichung wurden in der folgenden Tabelle die Strahlprofile in zwei Ebenen berechnet. Die folgende Tabelle zeigt die entsprechenden Ergebnisse für verschiedene relative Winkelstellungen zwischen den beiden Elementen.

| Winkelversatz Element 2 [Anzahl Facetten] | Seitliche Ansicht (mit übertriebenen Facetten-Winkeln) | Spotform [Ring-Ø in µm] | Anteile Leistung [%] | Intensitätsprofil bei z=0mm Fokusebene (1x1mm) | Intensitätsprofil bei z=0,35mm (1x1mm) |
|---|---|---|---|---|---|
| 0 | 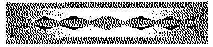 | 600/0 | 98/2 | 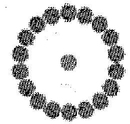 | 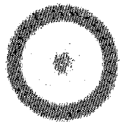 |
| 0,33 | 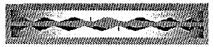 | 600/0 | 68,5/31,5 | 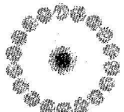 | 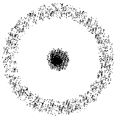 |
| 0,5 | 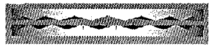 | 600/0 | 51,5/48,5 | 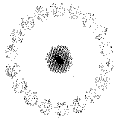 | 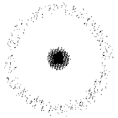 |
| 0,66 | 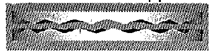 | 600/0 | 35,2/64,8 | 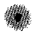 | 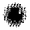 |
| 1 | 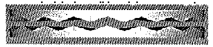 | 600/0 | 0,1/99,9 | 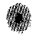 | 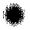 |
| Ohne Siemenssterne | 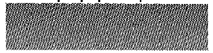 | 0 | 100 | 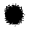 | 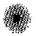 |

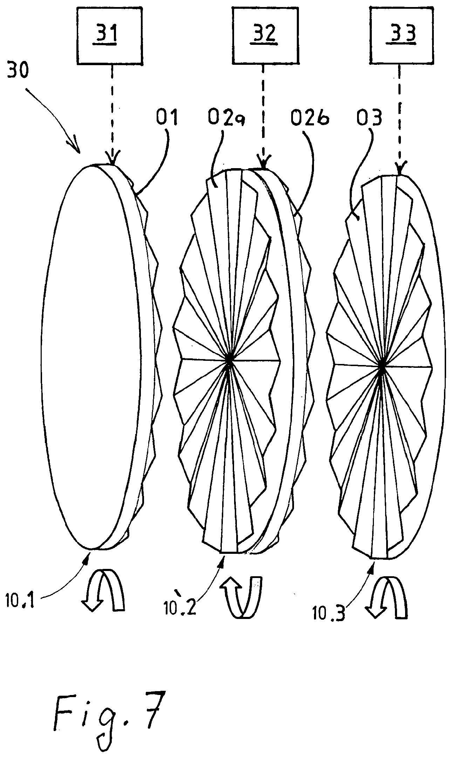

Die erfindungsgemäße Einstelloptik 20 lässt sich aber auch mit mehr als zwei Elementen aufbauen, wie dies beispielsweise in Figur 7 dargestellt ist. Um hier wiederum eine vollkommene Kompensation der Strahlablenkungen der einzelnen Elemente zu erhalten und um so die verschiedenen Strahlprofile optimal kombinieren zu können, ist es zweckmäßig, wenn bei drei optischen Elementen der Neigungswinkel der Facetten eines Elements doppelt so groß ist wie der Neigungswinkel der Facetten der beiden anderen optischen Elemente, bei denen der Neigungswinkel gleich ist. Soll eine Einstelloptik mit vier Elementen aufgebaut werden, so muss der Neigungswinkel der Facetten beim vierten Element so groß sein wie die Summe der Neigungswinkel der Facetten der drei anderen Elemente. Beträgt also beispielsweise der Neigungswinkel bei den ersten beiden Elementen +/- 0,1° und der Winkel beim dritten Element +/- 0,2°, so wäre der Neigungswinkel der Facetten beim vierten Element mit +/- 0,4° zu wählen.

Bei einer Simulation wurde eine Einstelloptik mit drei optischen Elementen mit siemenssternförmigen Facetten, also mit drei Siemenssternoptiken 10 eingesetzt, wobei die Facetten eines der Elemente doppelt so stark geneigt (+/- 0,2°) waren wie die Facetten der anderen beiden Elemente, die nur um +/- 0,1° geneigt waren. Diese beiden waren jeder für sich drehbar. Hierdurch können sowohl ein punktförmiger Fokus als auch zwei Ringe mit verschiedenen Durchmessern (600 µm und 300 µm) sowie beliebige Mischformen erzeugt werden. Hier wurde ebenso wie oben beschrieben, eine mögliche Fertigungstoleranz durch Abflachungen der Spitzen und Senken berücksichtigt.

Die Ergebnisse der Simulation zeigt die folgende Tabelle:

| Winkelversatz Element 2 [Anzahl Facetten] | Winkelversatz Element 3 [Anzahl Facetten] | Spotform [Ring-Ø in µm] | Anteile Leistung [%] | Intensitätsprofil bei z = 0 mm (Fokusebene) (1x1mm) | Intensitätsprofil bei z = 0,35mm (1x1mm) |
|---|---|---|---|---|---|
| 0 | 0 | 600/0 | 98/2 | 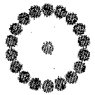 | 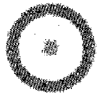 |
| 1 | 0 | 300/0 | 98/2 | 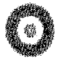 | 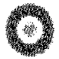 |
| 0 | 1 | 300/0 | 98/2 | 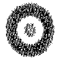 | 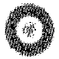 |
| 1 | 1 | 0 | 100 | 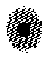 | 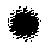 |
| 0,5 | 1 | 300/0 | 50/50 | 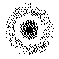 | 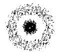 |
| 1 | 0,5 | 300/0 | 50/50 | 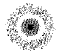 | 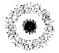 |
| 0 | 0,5 | 600/300 | 50/50 | 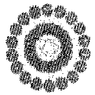 | 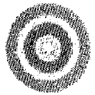 |
| 0,5 | 0 | 600/300 | 50/50 | 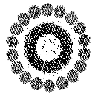 | 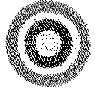 |
| 0,5 | 0,5 | 600/0 | 50/50 | 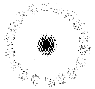 | 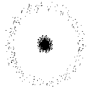 |
| 0,33 | 0,66 | 600/300/0 | 33/33/33 | 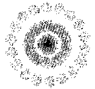 | 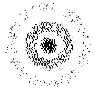 |
| 0,66 | 0,33 | 600/300/0 | 33/33/33 | 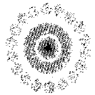 | 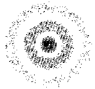 |
| 0,33 | 0 | 600/300 | 66/33 | 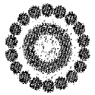 | 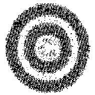 |
| 0 | 0,33 | 600/300 | 66/33 | 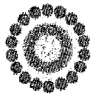 | 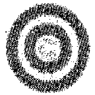 |
| 0,66 | 0 | 600/300 | 33/66 | 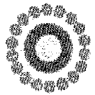 | 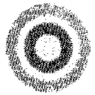 |
| 0 | 0,66 | 600/300 | 33/66 | 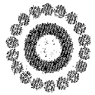 | 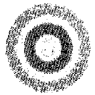 |
| Ohne SiemenssternOptiken | | 0 | 100 | 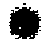 | 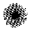 |

In der obigen Tabelle zeigt die erste Zeile die Einstellung der Elemente gegeneinander bei der sich die Strahlablenkungen optimal addieren, was zu dem mit der Vorrichtung erreichbaren größten Durchmesser führt. Die Zeilen 2 und 3 zeigen die Ergebnisse bei Winkelstellungen bei dem sich die Wirkungen der beiden Elemente mit gleichen Neigungswinkeln optimal aufheben, so dass der Ringdurchmesser nur von dem Neigungswinkel der Facetten des Elements mit großem Neigungswinkel bestimmt wird. In der vierten Zeile ist gezeigt, wie die Intensitätsverteilung im Fokus ist, wenn die Elemente so gegeneinander verdreht werden, dass sich ihre Stahlablenkungen optimal aufheben. Dieses Ergebnis entspricht dem in der letzten Zeile der Tabelle gezeigten Vergleichsbeispiel ohne Einstelloptik.

In den restlichen Zeilen der Tabelle sind beliebige Mischformen dargestellt.

Wird eine erfindungsgemäße Einstelloptik beispielsweise in einem Laserschneidkopf mit einer Kollimatorlinse und einer Fokussierlinse mit jeweils 100 mm Brennweite eingesetzt, der über eine 100 µm Faser mit einer numerischen Apertur von 0,12 mit Laserstrahlung versorgt wird, kann mit der erfindungsgemäßen Einstelloptik mit 2 Elementen schnell zwischen den Zuständen Ring und Spot (Punkt) umgeschaltet werden. Damit ist es möglich, zwischen den Betriebsarten "dickes Blech", für die ein Fokus mit großem Durchmesser erforderlich ist, und "dünnes Blech" umschalten, für die nur ein punktförmiger Laserfokus erforderlich ist. Wie sich durch die Simulationen gezeigt hat, ist es darüber hinaus auch möglich, durch Drehen um weniger als eine Facette also um einen Winkel, der kleiner ist als der Winkel einer Facette, Mischzustände von ringförmigen und punktförmiger Strahlcharakteristik herzustellen, so dass je nach Einsatz beim Laserschneiden die optimale Energieverteilung im Strahlprofil gewählt werden kann.

Wird bei einer praktischen Ausgestaltung der Erfindung eine Einstelloptik eingesetzt, deren plattenförmige optische Elemente (Siemenssternoptiken) einen Durchmesser von 30 mm und 18 Doppelfacetten also 36 Facetten mit einem Sektorwinkel 10° aufweisen, so verschiebt sich bei einer Verdrehung der beiden Siemenssternoptiken um eine Facette der Rand, um 2,6 mm. Eine derartige Verschiebung lässt sich mit hoher Geschwindigkeit realisieren, wenn beispielsweise die bewegliche Optik in nicht näher dargestellter Weise in einer Hohlwelle gefasst ist, die von einem Schrittmotor angetrieben wird, der den Rand der verdrehbaren Siemenssternoptik mit einer Geschwindigkeit von v = 250 mm/s bewegen kann. Es ergibt sich dann eine Schaltzeit von ca. 10 ms, so dass praktisch ohne Unterbrechung von Ring auf Spot oder umgekehrt umgeschaltet werden kann.

Mit einer Einstelloptik 20, die aus zwei oder mehr Siemenssternoptiken 10 aufgebaut ist, lässt sich aber nicht nur von Ring auf Spot oder umgekehrt umschalten, sondern es ist auch möglich zur Erhöhung der Qualität beim Laserschneiden und Laserschweißen die räumliche Intensitätsverteilung eines auf ein Werkstück fokussierten Laserstrahls hochfrequent zu modulieren. Dazu ist eine Einstelloptik 20 mit zwei oder mehr hintereinander stehenden Siemenssternoptiken 10 nötig, von denen mindestens eine um die optische Achse drehbar gelagert ist und in Rotation versetzt werden kann. Wie oben gesagt, kann die Einstelloptik 20 im kollimierten, divergenten oder konvergenten Teil des Strahlengangs angeordnet sein.

Um die erzeugte Intensitätsverteilung in der Fokusebene von Spot auf Ring umzuschalten, genügt eine Relativdrehung der Siemenssternoptiken 10 mit N Doppelsegmenten (Doppelfacetten) von 360°/2N. Bei einer Relativdrehung um 360°/N erfolgt ein Wechsel von Spot zu Ring und wieder zu Spot, dies entspricht also einer Schwingungsperiode.

Daraus folgt, dass die Modulationsfrequenz der Intensitätsverteilung dem N-fachen der relativen Drehfrequenz der Siemenssternoptiken 10 entspricht. Somit stellt ein Paar von Siemenssternoptiken 10 ein optisches Getriebe dar, das bereits bei kleinen Drehfrequenzen einer oder aller Siemenssternoptiken 10 eine hohe Modulationsfrequenz für die Intensitätsverteilung des Laserstrahls 14 in der Fokusebene liefert.

Wird beispielsweise eine Einstelloptik 20 mit zwei Siemenssternoptiken 10, deren Siemenssternflächen jeweils N=20 Doppelfacetten oder -segmente aufweisen, und ein Antrieb für mindestens eine der Siemenssternoptiken 10 mit einer Drehfrequenz von 100 Hz eingesetzt, so wird die Intensitätsverteilung zwischen den Modi Spot und Ring mit einer Frequenz von 2 kHz moduliert.

Insbesondere sind folgende Betriebsmodi sind denkbar:
- Nur eine der Siemenssternoptiken 10 wird mit der Frequenz f gedreht. Die Modulationsfrequenz entspricht dann N*f.
- Beide Siemenssternoptiken 10 werden zueinander entgegengesetzt mit den Drehfrequenzen f1 und f2 gedreht. Die Modulationsfrequenz entspricht N*(f1+f2).

Werden mehr als zwei Siemenssternoptiken eingesetzt, so
- können ringförmige Intensitätsverteilungen mit verschiedenen Durchmessern erzeugt werden, wie oben bereits erläutert wurde; außerdem
- kann die Modulationsfrequenz weiter erhöht werden.

Hierzu muss sich jede Siemenssternoptik stets entgegengesetzt zu ihrer benachbarten Siemenssternoptik drehen. Die Modulationsfrequenz ergibt sich bei M Siemenssternen mit den Drehfrequenzen fᵢ zu N*(Σ_{M} fᵢ). Werden beispielsweise drei Siemenssternoptiken mit N=20 Doppelfacetten und einer Drehfrequenz von je 100 Hz eingesetzt, so wird die Intensitätsverteilung zwischen den Modi Spot und Ring mit einer Frequenz von 6 kHz moduliert.

Als Beispiel soll eine Konfiguration dienen wie sie in Figur 7 dargestellt ist. Wie in Figur 7 gezeigt weist eine Einstelloptik 30 drei Siemenssternoptiken 10.1, 10'.2 und 10.3 auf, wobei die mittlere Siemenssternoptik 10'.2 beidseitig strukturiert ist. Insgesamt sind also vier Siemenssternflächen O1, O2a, O2b, O3 mit je N Doppelfacetten vorgesehen.Die beiden einander gegenüber stehenden Siemenssternflächen O1 und O2a haben die gleiche Facettensteigung oder Neigungswinkel β₁. Auch die beiden anderen einander gegenüberstehend Siemenssternflächen O2b und O3 haben die gleiche Facettensteigung oder Neigungswinkel β₂, wobei in nicht näher dargestellter Weise der Neigungswinkel β₁ verschieden vom Neigungswinkel β₂ ist. Durch Drehung der Siemenssternoptik 10.1 relativ zur Siemenssternoptik 10'.2 kann die gemeinsame Ringform der Siemenssternflächen O1 und O2a geschaltet werden. Gleiches gilt für die Siemenssternoptiken 10'.2 und 10.3 und die Siemenssternflächen O2b und O3.

Wie in Figur 7 angedeutet, ist jeder der drei Siemenssternoptiken 10.1, 10'.2 und 10.3 ein Drehantrieb 31, 32 bzw. 33 zugeordnet, so dass alle drei Siemenssternoptiken 10.1, 10'.2 und 10.3 mit der Frequenz f drehbar sind. Die Drehrichtung der mittleren Siemenssternoptik 10'.2 ist dabei entgegengesetzt zu der Drehrichtung der anderen beiden, wie durch die Drehrichtungspfeile P angedeutet ist. Werden unterschiedliche Drehfrequenzen der drei Siemenssternoptiken 10.1, 10'.2 und 10.3 erlaubt, so erhöht sich insbesondere die Anzahl der Intensitätsverteilungen, die während einer Periode generiert werden.

Eine Auswahl der verschiedenen Betriebsmodi der anhand von Figur 7 beschriebenen Anordnung wird durch folgende Tabelle wiedergegeben:

| **Stellung 10.1** | **Stellung 10'.2** | **Stellung 10.3** | **Intensitätsverteilungen Während einer Periode** | **Modulationsfrequenz** |
|---|---|---|---|---|
| rotiert mit f | in Ruhe, Spot | | Ø₁ Sp | N*f |
| rotiert mit f | in Ruhe, Ring | | Ø₂ Ø₃ | N*f |
| in Ruhe, Spot | | rotiert mit f | Ø₂ Sp | N*f |
| in Ruhe, Ring | | rotiert mit f | Ø₁ Ø₃ | N*f |
| in Ruhe | rotiert mit f | in Ruhe, in Phase mit 10.1 | Ø₃ Sp | N*f |
| in Ruhe | rotiert mit f | in Ruhe, 180° PV zu 10.1 | Ø₁ Ø₂ | N*f |
| rotiert mit f | in Ruhe | rotiert mit f, in Phase mit 10.1 | Ø₃ Sp | 2*N*f |
| rotiert mit f | in Ruhe | rotiert mit f, 180° PV zu 10.1 | Ø₁ Ø₂ | 2*N*f |
| rotiert mit f | rotiert mit f | rotiert mit f, in Phase mit 10.1 | Ø₃ Sp | 3*N*f |
| rotiert mit f | rotiert mit f | rotiert mit f, 180° PV mit 10.1 | Ø₁ Ø₂ | 3*N*f |

Hier bedeutet PV = Phasenverschiebung, Sp = Spot-förmige Intensitätsverteilung und □ Øi = Durchmesser der ringförmigen Intensitätsverteilung

Durch das Zusammenspiel der kontinuierlichen Rotation der Siemenssternoptiken 10; 10.1, 10'.2, 10.3 mit der optischen Getriebewirkung eines oder mehrerer Siemensstern-Paare wird die erzeugte Intensitätsverteilung im Fokus mit dem N-fachen der Drehfrequenz oder mit dem N-fachen der Summe der Drehfrequenzen moduliert, wobei N die Anzahl der Doppelfacetten pro Siemenssternoptik 10; 10.1, 10'.2, 10.3 ist.

Aufgrund der optischen Getriebewirkung sind die Anforderungen an die Rotationsgeschwindigkeit gering. Um eine oder mehrere Siemenssternoptiken mit zwei- oder dreistelliger Drehfrequenz in Rotation zu versetzen, können als Drehantriebe elektrische Antriebe mit mit unterschiedlichen Antriebsmechanismen eingesetzt werden, die auf dem Markt verfügbar sind.

Alternativ zu einem elektrischen Antrieb ist es auch denkbar, einen Drehantrieb mittels Druckluft zu realisieren. Die Gaszufuhr ist in der Regel gegeben, da Druckluft (und/oder Schneidgas) im Bereich des Laserbearbeitungskopfs in der Regel zur Verfügung steht.

Auf dem Markt gibt es ferner auch Drehantriebe, die eine Optik, wie eine Siemenssternoptik mit besonders hohen Drehfrequenzen von bis zu 6kHz rotieren können. Angewandt auf das obige Beispiel mit zwei Siemenssternoptiken mit N=20 Doppelfacetten, erreicht man hiermit Modulationsfrequenzen von bis 120kHz.

Bereits ab einer Modulationsfrequenz im 2-stelligen kHz Bereich nimmt das zu bearbeitende Blech nur noch die über eine Modulationsperiode gemittelte Intensitätsverteilung wahr, da aufgrund der relativen Trägheit der Wärmeleitung die eingetragene Leistung nicht mehr schnell genug umverteilen kann. Somit wirkt die Modulation der Intensitätsverteilung wie eine dauernde Strahlaufweitung und kann daher aufwändige Zoom-Systeme ersetzen oder ergänzen.

In allen Fällen und Konfigurationen ist der erfindungsgemäße Laserbearbeitungskopf vorteilhafterweise auch stets zum Dünnblechschweißen oder -schneiden geeignet, da die Ringformung durch geeignete feste Winkelstellung aller verwendeten Siemenssternoptiken deaktiviert werden kann, um den Laserbearbeitungskopf im Modus Spot zu betreiben.

## Patentansprüche

1. Vorrichtung zur Materialbearbeitung mittels Laserstrahlung mit einer Fokussieroptik (15) zur Fokussierung eines Laserstrahls (14) auf ein Werkstück (18) und mit einer Einstelloptik (20) zum Einstellen der Intensitätsverteilung mit zumindest einem plattenförmigen optischen Element (10), das eine Fläche mit einem kreisförmigen Muster aus sektorförmigen Facetten aufweisen, **dadurch gekennzeichnet, dass** die sektorförmigen Facetten in Umfangsrichtung abwechselnd gegen die jeweilige Plattenebene geneigt sind.

2. Vorrichtung nach Anspruch 1, **dadurch gekennzeichnet, dass** das plattenförmige optische Element (10) der Einstelloptik (20) in den Strahlengang des Laserstrahls (14) hinein und heraus bewegbar ist.

3. Vorrichtung nach Anspruch 1, **dadurch gekennzeichnet, dass** die Einstelloptik (20) zumindest zwei plattenförmige optische Elemente (10) mit jeweils einem kreisförmigen Muster aus sektorförmigen Facetten, die in Umfangsrichtung abwechselnd gegen die jeweilige Plattenebene geneigt sind, aufweist, wobei die zumindest zwei plattenförmigen optischen Elemente (10) hintereinander im Strahlengang des Laserstrahls (14) angeordnet und gegeneinander in Umfangsrichtung verdrehbar sind.

4. Vorrichtung nach Anspruch 1, 2 oder 3, **dadurch gekennzeichnet, dass** alle sektorförmigen Facetten eines plattenförmigen optischen Elements (10) dieselbe azimutale Breite aufweisen, und/oder dass die Flächen der sektorförmigen Facetten der plattenförmigen optischen Elemente (10) eben oder gekrümmt sind oder zwei oder mehrere unterschiedlich geneigte Abschnitte aufweisen.

5. Vorrichtung nach Anspruch 3 oder 4, **dadurch gekennzeichnet, dass** die beiden plattenförmigen optischen Elemente (10) der Einstelloptik (20) sich mit ihren sektorförmigen Facettenmustern gegenüber stehen.

6. Vorrichtung nach einem der Ansprüche 3 bis 5, **dadurch gekennzeichnet, dass** die beiden plattenförmigen optischen Elemente (10) der Einstelloptik (20) um eine Achse verdrehbar sind, die mit einer Mittelachse eines Laserstrahlbündels (14) koaxial ist.

7. Vorrichtung nach einem der Ansprüche 3 bis 6, **dadurch gekennzeichnet, dass** die sektorförmigen Facettenmuster der beiden plattenförmigen optischen Elemente (10) der Einstelloptik (20) dieselbe Anzahl von Facetten aufweist und dass die Facettenflächen um den gleichen Winkel (β) geneigt sind.

8. Vorrichtung nach einem der Ansprüche 3 bis 7, **dadurch gekennzeichnet, dass** die Einstelloptik (20) ein weiteres plattenförmiges optisches Element (10) mit einem sektorförmigen Facettenmuster aufweist.

9. Vorrichtung nach Anspruch 8, **dadurch gekennzeichnet, dass** das weitere plattenförmige optische Element (10) auf beiden Seiten ein sektorförmiges Facettenmuster aufweist und zwischen den beiden ersten plattenförmigen optischen Elemente (10) angeordnet ist.

10. Vorrichtung nach Anspruch 8, **dadurch gekennzeichnet, dass** das weitere plattenförmige optische Element (10) ein sektorförmiges Facettenmuster aufweist, das von dem sektorförmigen Facettenmustern der beiden ersten plattenförmigen optischen Elemente (10) verschieden ist, wobei die Facettenflächen des weiteren plattenförmigen optischen Elements (10) um einen Winkel (β) gegen die Plattenebene geneigt sind, der vom Neigungswinkel der beiden ersten plattenförmigen optischen Elemente (10) verschieden, insbesondere so groß ist wie die Summe der Neigungswinkel der beiden ersten plattenförmigen optischen Elemente (10), und/oder wobei die Facetten des weiteren plattenförmigen optischen Elements (10) eine azimutale Breite aufweisen, die von der azimutale Breite der Facetten der beiden ersten plattenförmigen optischen Elemente (10) verschieden ist.

11. Vorrichtung nach einem der vorstehenden Ansprüche, **dadurch gekennzeichnet, dass** der Neigungswinkel der Facettenflächen gegen die Plattenebene zwischen +/- 0,1° und +/-0,6° beträgt, und/oder dass die Anzahl der Facetten 18 bis 72, vorzugweise 24 bis 40, insbesondere 36 beträgt.

12. Vorrichtung nach einem der vorstehenden Ansprüche, **dadurch gekennzeichnet, dass** eine Kollimatoroptik (17) zur Aufweitung des Laserstrahls (14) vorgesehen ist, und dass die Einstelloptik (20) zwischen der Kollimatoroptik (17) und der Fokussieroptik (15) angeordnet ist.

13. Vorrichtung nach einem der vorstehenden Ansprüche, **dadurch gekennzeichnet, dass** zumindest einem der plattenförmigen optischen Elemente (10) ein Drehantrieb (31, 32, 33) zugeordnet ist, so dass das plattenförmige optische Elemente (10) während eines Laserbearbeitungsprozesses antreibbar ist, um mit konstanter oder veränderlicher Geschwindigkeit zu rotieren.

14. Vorrichtung nach Anspruch 13, **dadurch gekennzeichnet, dass** das jedem der plattenförmigen optischen Elemente (10; 10.1, 10'.2, 10.3) ein Drehantrieb (31, 32, 33) zugeordnet ist, wobei die Drehantriebe (31, 32, 33) insbesondere unabhängig voneinander ansteuerbar sind, so dass die Drehgeschwindigkeit und Drehrichtung jedes der plattenförmigen optischen Elemente (10; 10.1, 10'.2, 10.3) frei gewählt werden kann.

15. Verfahren zur Materialbearbeitung mittels Laserstrahlung unter Verwendung einer Fokussieroptik (15) zur Fokussierung eines Laserstrahls (14) auf ein Werkstück (18) und einer Einstelloptik (20) zum Einstellen der Intensitätsverteilung, die zumindest zwei plattenförmige optische Elemente (10) aufweist, **dadurch gekennzeichnet, dass** die zumindest zwei plattenförmigen optischen Elemente jeweils ein kreisförmiges Muster aus sektorfömigen Facetten aufweisen, die in Umfangsrichtung abwechselnd gegen die jeweilige Plattenebene geneigt sind, wobei die zumindest zwei plattenförmigen optischen Elemente (10) hintereinander im Strahlengang des Laserstrahls (14) angeordnet und in Umfangsrichtung drehbar sind, bei dem während der Laserbearbeitung zumindest eines der plattenförmigen optischen Elemente (10) mit konstanter oder variabler Geschwindigkeit gedreht wird, um eine Leistungsdichteverteilung mit einer gewünschten Modulationsfrequenz zu variieren.

16. Verfahren nach Anspruch 15, **dadurch gekennzeichnet, dass** beide der zumindest zwei plattenförmigen optischen Elemente (10) in entgegengesetzte Richtungen mit gleicher oder unterschiedlicher Geschwindigkeit gedreht werden, und/oder dass bei der Laserbearbeitung, während eines oder mehrere der plattenförmigen optischen Elemente (10) gedreht werden, die Ausgangsleistung des Lasers moduliert wird, wobei eine Modulationsfrequenz des Lasers an die Modulationsfrequenz der Leistungsdichteverteilung gekoppelt ist.

## Claims

1. A device for machining material by means of laser radiation including a focusing optics (15) for focusing a laser beam (14) onto a workpiece (18) and an adjusting optics (20) for adjusting the intensity distribution including at least one plate-shaped optical element (10) having a circular pattern of sector-shaped facets, **characterized in that**, in the circumferential direction, the sector-shaped facets are alternately inclined with respect to the respective plate plane.

2. The device according to claim 1, **characterized in that** said plate-shaped optical element (10) of said adjusting optics (20) is movable into and out of the beam path of said laser beam (14).

3. The device according to claim 1, **characterized in that** said adjusting optics (20) includes at least two plate-shaped optical elements (10), each having a circular pattern of sector-shaped facets which, in the circumferential direction, are alternately inclined with respect to the respective plate plane, wherein said at least two plate-shaped optical elements (10) are arranged one behind another in the beam path of said laser beam (14) and are rotatable relative to one another in the circumferential direction.

4. The device according to claim 1, 2 or 3, **characterized in that** all sector-shaped facets of a plate-shaped optical element (10) have the same azimuthal width and/or that the surfaces of the sector-shaped facets of said plate-shaped optical elements (10) are planar or curved or have two or more differently inclined portions.

5. The device according to claim 3 or 4, **characterized in that** said two plate-shaped optical elements (10) of said adjusting optics (20) face each other with their sector-shaped facet patterns.

6. The device according to any one of the claims 3 to 5, wherein said two plate-shaped optical elements (10) of said adjusting optics (20) are rotatable about an axis which is coaxial with a central axis of a laser beam bundle (14).

7. The device according to any one of claim 3 to 6, **characterized in that** the sector-shaped facet patterns of said two plate-shaped optical elements (10) of said adjusting optics (20) have the same number of facets and that the facet surfaces are inclined by the same angle (β).

8. The device according to any one of claims 3 to 7, wherein said adjusting optics (20) comprises a further plate-shaped optical element (10) having a sector-shaped facet pattern.

9. The device according to claim 8, **characterized in that** said further plate-shaped optical element (10) has a sector-shaped facet pattern on both sides and is arranged between the two first plate-shaped optical elements (10).

10. The device according to claim 8, **characterized in that** said further plate-shaped optical element (10) has a sector-shaped facet pattern which is different from the sector-shaped facet pattern of said two first plate-shaped optical elements (10), wherein the facet surfaces of said further plate-shaped optical element (10) are inclined by an angle (β) with respect to the plate plane which differs from the inclination angle of said two first plate-shaped optical elements (10), in particular is as large as the sum of the inclination angles of said two first plate-shaped optical elements (10) und/oder wherein the facets of said further plate-shaped optical element (10) have an azimuthal width which is different from the azimuthal width of the facets of said two first plate-shaped optical elements (10).

11. The device according to any one the preceding claims, wherein the inclination angle of the facet surfaces with respect to the plate plane is between ±0.1° and ±0.6° und/oder that the number of facets is 18 to 72, preferably 24 to 40, in particular 36.

12. The device according to any one of the preceding claims, **characterized in that** a collimator optics (17) is provided for widening said laser beam (14), and said adjusting optics (20) is arranged between said collimator optics (17) and said focusing optics (20).

13. The device according to any one of the preceding claims, **characterized in that** a rotary drive (31, 32, 33) is assigned to at least one of said plate-shaped optical elements (10) so that the plate-shaped optical element (10) is drivable during a laser machining process so as to rotate at a constant or variable speed.

14. The device according to claim 13, **characterized in that** a rotary drive (31, 32, 33) is assigned to each of said plate-shaped optical elements (10; 10.1, 10'.2, 10.3), wherein said rotary drives (31, 32, 33) are controllable independently of one another, so that the rotational speed and the direction of rotation of each of said plate-shaped optical elements (10; 10.1, 10'.2, 10.3) can be freely selected.

15. A method for machining material by means of laser radiation using a focusing optics (15) for focusing a laser beam (14) onto a workpiece (18) and an adjusting optics (20) for adjusting the intensity distribution including at least one plate-shaped optical element (10) **characterized in that** the at least two plate-shaped optical elements (10) each have a circular pattern of sector-shaped facets which, in the circumferential direction, are alternately inclined with respect to the respective plate plane,
wherein said at least two plate-shaped optical elements (10) are arranged one behind another in the beam path of said laser beam (14) and are rotatable relative to one another in the circumferential direction, wherein, during laser machining, at least one of the plate-shaped optical elements (10) is rotated at a constant or variable speed so as to vary a power density distribution by a desired modulation frequency.

16. The method according to claim 15, **characterized in that** both of the at least two plate-shaped optical elements (10) are rotated in contrary directions with the same or different speed, and/or that, when laser machining, during rotation of one or more said plate-shaped optical elements (10), the output power of the laser is modulated, wherein a modulation frequency of the laser is coupled to the modulation frequency of the power density distribution.

## Revendications

1. Dispositif d'usinage de matériau par rayonnement laser au moyen d'un rayonnement laser comportant une optique de focalisation (15) pour focaliser un rayon laser (14) sur une pièce à usiner (18) et comportant une optique de réglage (20) pour régler la distribution d'intensité et comportant au moins un élément optique en forme de plaque (10), qui présente une surface avec un motif circulaire composé de facettes en forme de secteur, **caractérisé en ce que** les facettes en forme de secteur sont inclinées dans la direction circonférentielle en alternance en sens opposé au plan de plaque respectif.

2. Dispositif selon la revendication 1, **caractérisé en ce que** l'élément optique en forme de plaque (10) de l'optique de réglage (20) est déplaçable dans le trajet optique du rayon laser (14) d'avant en arrière.

3. Dispositif selon la revendication 1, **caractérisée en ce que** l'optique de réglage (20) présente au moins deux éléments optiques en forme de plaque (10) avec respectivement un motif circulaire composé de facettes en forme de secteur, qui sont inclinées dans la direction circonférentielle en alternance en sens opposé au plan de plaque respectif, dans lequel les au moins deux éléments optiques en forme de plaque (10) sont disposés l'un derrière l'autre dans le trajet de rayon du rayon optique (14) et peuvent être tournés en sens opposés l'un à l'autre dans la direction circonférentielle.

4. Dispositif selon la revendication 1, 2 ou 3, **caractérisé en ce que** toutes les facettes en forme de secteur d'un élément optique en forme de plaque (10) présente la même largeur azimutale et/ou **en ce que** les surfaces des facettes en forme de secteur des éléments optiques en forme de plaques (10) sont plates ou incurvées ou présentent deux ou plusieurs sections inclinées différentes.

5. Dispositif selon la revendication 3 ou 4, **caractérise en ce que** les deux éléments optiques en forme de plaque (10) de l'optique de réglage (20) se font face avec leurs motifs de facettes en forme de secteur.

6. Dispositif selon une des revendications 3 à 5, **caractérisé en ce que** les deux éléments optiques en forme de plaque (10) de l'optique de réglage (20) sont rotatifs autour d'un axe qui est coaxial avec un axe central d'un faisceau de rayon laser (14).

7. Dispositif selon une des revendications 3 à 6, **caractérisé en ce que** les motifs à facettes en forme de secteur des deux éléments optiques en forme de plaques (10) de l'optique de réglage (20) présentent le même nombre de facettes et **en ce que** les surfaces à facettes sont inclinées du même angle (β).

8. Dispositif selon une des revendications 3 à 7, **caractérisé en ce que** l'optique de réglage (20) présente un élément optique en forme de plaque supplémentaire (10) avec un motif à facettes en forme de secteur.

9. Dispositif selon la revendication 8, **caractérisé en ce que** un élément optique en forme de plaque supplémentaire (10) présente des deux côtés un motif à facettes en forme de secteur et est disposé entre les deux premiers éléments optiques en forme de plaque (10) .

10. Dispositif selon la revendication 8, **caractérisé en ce que** l'élément optique supplémentaire en forme de plaque (10) présente un motif à facettes en forme de secteur, qui est différent des motifs à facettes en forme de secteur des deux premiers éléments optiques en forme de plaque (10), dans lequel les surfaces à facettes de l'élément optique supplémentaire en forme de plaque (10) sont inclinées d'un angle (β) en sens inverse au plan de plaque, qui est différent de l'angle d'inclinaison des deux premiers éléments optiques en forme de plaque (10), notamment est aussi grand que la somme de l'angle d'inclinaison des deux premiers éléments optiques en forme de plaque (10) et/ou dans lequel les facettes de l'élément optique en forme de plaque supplémentaire (10) présente une largeur azimutale, qui est différente de la largeur azimutale des facettes des deux premiers éléments optiques en forme de plaque (10).

11. Dispositif selon une des revendications précédentes, **caractérisé en ce que** l'angle d'inclinaison des surfaces de facettes en sens opposé au plan de plaque est compris entre ± 0,1° et ± 0,6° et/ou **en ce que** le nombre de facettes est compris entre 18 et 72, de préférence entre 24 et 40, notamment s'élève à 36.

12. Dispositif selon une des revendications précédentes, **caractérise en ce que** une optique de collimateur (17) pour élargir le rayon laser (14) est prévue et **en ce que** l'optique de réglage (20) est disposée entre l'optique de collimateur (17) et l'optique de focalisation (15).

13. Dispositif selon une des revendications précédentes, **caractérisé en ce que** au moins un des éléments optiques en forme de plaque (10) est coordonnée à un entraînement rotatif (31, 32, 33), de sorte que l'élément optique en forme de plaque (10) puisse être entraîné pendant un processus d'usinage laser afin de tourner en rotation avec une vitesse constante ou variable.

14. Dispositif selon la revendication 13, **caractérisé en ce que** un entraînement rotatif (31, 32, 33) est coordonné à chacun des éléments rotatifs en forme de plaque (10 ; 10.1, 10'.2, 10.3), dans lequel les entraînements rotatifs (31, 32, 33) peuvent être commandés indépendamment les uns des autres de sorte que la vitesse de rotation et la direction de rotation de chacun des éléments optiques en forme de plaque (10 ; 10.1, 10'.2, 10.3), puisse être choisie librement.

15. Procédé d'usinage de matériau au moyen d'un rayonnement laser en utilisant une optique de focalisation (15) pour focaliser un rayonnement laser (14) sur une pièce à usiner (18) et une optique de réglage (20) pour régler la distribution d'intensité, qui présente au moins deux éléments optiques en forme de plaque (10), **caractérisé en ce que** les au moins deux éléments optiques en forme de plaque présentent respectivement un motif circulaire composé de facettes en forme de secteur, qui sont inclinées dans la direction circonférentielle en alternance en sens opposé au plan de plaque respectif, dans lequel au moins deux éléments optiques en forme de plaque (10) sont disposés l'un derrière l'autre dans le trajet optique du rayon laser (14) est rotatif dans la direction circonférentielle, dans lequel pendant l'usinage laser au moins un des éléments optiques en forme de plaque (10) est tourné avec une vitesse constante ou variable, afin de varier une distribution de densité de puissance avec une fréquence de modulation souhaitée.

16. Procédé selon la revendication 15, **caractérise en ce que** les deux d'au moins deux des éléments optiques en forme de plaque (10) sont tournés dans des directions opposées avec une vitesse identique ou différente et/ou **en ce que** lors de l'usinage laser, pendant qu'un ou plusieurs des éléments optiques en forme de plaque (10) sont tournés, la puissance de sortie du laser est modulée, dans lequel une fréquence de modulation du laser est couplée à la fréquence de modulation de la distribution de la densité de puissance.
